# EUROPÄISCHE PATENTSCHRIFT

(11) **EP 3 830 660 B1**
(45) Veröffentlichungstag und Bekanntmachung des Hinweises auf die Patenterteilung: **13.04.2022**
(21) Anmeldenummer: 19769055.5
(22) Anmeldetag: 30.08.2019
(51) Int. Cl.: G05B 23/02

(54) **VERFAHREN UND ASSISTENZSYSTEM ZUR PARAMETRISIERUNG EINES ANOMALIEERKENNUNGSVERFAHRENS**
METHOD AND ASSISTANCE SYSTEM FOR PARAMETERIZATION OF AN ANOMALY DETECTION METHOD
PROCÉDÉ ET SYSTÈME D'AIDE AU PARAMÉTRAGE D'UN PROCÉDÉ DE DÉTECTION D'ANOMALIES

(30) Priorität: 18.09.2018 EP 18195130
(43) Veröffentlichungstag der Anmeldung: 09.06.2021
(73) Patentinhaber: Siemens Aktiengesellschaft, 80333 München (DE)
(72) Erfinder: KEHRER, Johannes, 81829 München (DE); WEBER, Stefan Hagen, 81927 München (DE); PAULITSCH, Christoph, 76199 Karlsruhe (DE)
(86) Internationale Anmeldenummer: PCT/EP2019/073176
(87) Internationale Veröffentlichungsnummer: WO 2020/057937

(56) Entgegenhaltungen:
- US-A1- 2011 072 016
- Jens Dittrich ET AL: "Die Umgedrehte Vorlesung - Chancen für die Informatiklehre", Datenbank-Spektrum, 1. März 2014 (2014-03-01), Seiten 69-76, XP055525303, Berlin/Heidelberg DOI: 10.1007/s13222-013-0143-9 Gefunden im Internet: URL:http://www.dbs.ifi.lmu.de/Lehre/KDD/WS 0910/skript/kdd-5-clustering.pdf [gefunden am 2018-11-20]
- NAGARAJU S ET AL: "An effective density based approach to detect complex data clusters using notion of neighborhood difference", INTERNATIONAL JOURNAL OF AUTOMATION AND COMPUTING, ZHONGGUO KEXUE ZAZHISHE, CN, Bd. 14, Nr. 1, 29. Dezember 2016 (2016-12-29), Seiten 57-67, XP036141705, ISSN: 1476-8186, DOI: 10.1007/S11633-016-1038-7 [gefunden am 2016-12-29]

## Beschreibung

Die Erfindung betrifft ein Verfahren, ein Assistenzsystem sowie ein Computerprogrammprodukt zur Parametrisierung eines Anomalieerkennungsverfahrens, das basierend auf einer Vielzahl von Sensordatenpunkten ein dichtebasiertes Clusterverfahren in Echtzeit approximiert.

Eine datenbasierte Anomalieerkennung wird in Industrieanlagen dazu eingesetzt, unerwünschte oder gefährliche Betriebszustände von Maschinen oder sonstigen Komponenten der Anlage frühzeitig zu erkennen und rechtzeitig, beispielsweise durch Abschaltung oder Reparatur, darauf reagieren zu können.

Beispiele für Anomalien in Industrieanlagen, die anhand von meist durch Sensoren aufgenommene Daten erkannt werden sollen, sind ungewollte Produktionsminderungen, verschleißbedingte Gerätefehler, Abnutzungserscheinungen, Fehleinstellungen von Geräten, aber auch Nachfragerückgänge, Produktionsrückgänge oder Qualitätseinbußen.

Technische Verfahren zur Anomalieerkennung basieren üblicherweise auf einer bestimmten Parametrisierung, also der Auswahl von Eingangsparametern, der eingesetzten Algorithmen. Je besser die Abgrenzung von einem normalen zu einem anormalen Verhalten ist, desto besser kann ein regelgerechter Betrieb sichergestellt und Kosten durch Anomalien vermieden werden.

Ein weit verbreitetes Verfahren zur Anomalieerkennung ist das Trainieren eines dichtebasierten Clustering-Algorithmus auf Daten, insbesondere Sensordaten aus dem regelgerechten Betrieb, also Daten ohne Anomalien. Dieses Verfahren ist sehr trennscharf, aber schwierig zu parametrisieren. Bei zweidimensionalen Daten können die Ergebnisse aus dem Clustering-Algorithmus zur Überprüfung in Form eines Streudiagramms visualisiert werden, in dem die Punkte entsprechend ihres Anomaliestatus beziehungsweise ihrer Zugehörigkeit zu einem Cluster eingefärbt sind.

Eine richtige Einstellung der Parameterwerte solcher Clustering-Algorithmen, im Weiteren auch kurz als Clusterverfahren bezeichnet, ist wichtig, aber auch sehr zeitaufwändig. Schon eine geringe Abweichung der Parameterwerte vom domänenspezifischen und benutzerabhängigen Optimum kann zu veränderter Clusterbildung und damit schlechteren Erkennungsraten führen.

Die Druckschrift Jens Dittrich ET AL: "Die Umgedrehte Vorlesung - Chancen für die Informatiklehre", Datenbank-Spektrum, 1. März 2014 (2014-03-01), Seiten 69-76, XP055525303, Berlin/Heidelberg DOI: 10.1007/s13222-013-0143-9 betrachtet und erläutert dichtebasierte Clustering Verfahren und weist auf die Problematik bei der Wahl der optimalen Parameter für dieses Verfahren hin.

Es sind automatisierte Verfahren bekannt, welche Vorschläge zu einer initialen Parametrisierung eines dichtebasierten Clustering-Algorithmus liefern. Solche automatisierten Verfahren haben den Nachteil, dass die Parametrisierung aus einer Regel resultiert, welche das Optimum für einen konkreten Fall nur annähert, und keine aktuellen Informationen, wie zum Beispiel Kontext- und Domänenwissen eines Benutzers, berücksichtigt. Der Nutzer sollte möglichst auch verstehen, wie das automatisierte Verfahren zur Parameterbestimmung funktioniert und die Parameter bildet.

Des Weiteren muss ein Nutzer eines Clusterverfahrens, der den zugrundeliegenden Clustering-Algorithmus nicht im Detail nachvollziehen kann, trotzdem verstehen können, wie sich Änderungen der Parameterwerte des Algorithmus auf das Clusterergebnis auswirken. Deshalb ist es notwendig, dass ein Nutzer manuell geeignete Parameterwerte einstellt beziehungsweise nachjustiert. Dazu werden mindestens einer oder mehrere der Parameterwerte geändert und der Clustering-Algorithmus mit den neuen Parameterwerten gestartet. Die Berechnung der Clusterzugehörigkeit durch den Clustering-Algorithmus ist sehr zeitintensiv. Abhängig von der Anzahl der zugrunde liegenden Datenpunkte dauert die Berechnung von Sekunden bis zu Stunden. Anschließend kann das Clusterergebnis beispielsweise durch Visualisierung oder ausgegebene Fehlermaße ausgewertet werden. Um ein brauchbares Clusteringergebnis zu erhalten, sind häufig mehrfache Parameteränderungen und Berechnung der jeweiligen Clusterergebnisse notwendig.

Es ist somit die Aufgabe der vorliegenden Erfindung zeitoptimiert und unter Einbeziehung von Domänenwissen eines Benutzers, die Festlegung von Parametern für eine Anomalieerkennung zu beschleunigen.

Die Aufgabe wird durch die in den unabhängigen Ansprüchen beschriebenen Maßnahmen gelöst. In den Unteransprüchen sind vorteilhafte Weiterbildungen der Erfindung dargestellt.

Gemäß einem ersten Aspekt betrifft die Erfindung ein Verfahren zur Parametrisierung eines Anomalieerkennungsverfahrens, das basierend auf einer Vielzahl von Sensordatenpunkten ein dichtebasiertes Clusterverfahren durchführt, umfassend
a) Abbilden eines jeden Sensordatenpunktes in einem Datenraum in einen Pixeldatenpunkt in einem Pixelraum,
b) Nachbilden mindestens einer Operation des dichtebasierten Clusterverfahrens im Datenraum durch mindestens eine Pixeloperation im Pixelraum,
c) Empfangen von mindestens einem Parameterwert für jeden Parameter des dichtebasierten Clusterverfahrens,
d) Anwenden der mindestens einen Pixeloperation entsprechend den empfangenen Parameterwert auf die Pixeldatenpunkte,
e) Ausgabe eines Clusterergebnisses in visueller Form im Pixelraum, und
f) Bereitstellen der empfangenen Parameterwerte als Parameter für das Anomalieerkennungsverfahren.

Die Bezeichnungen Clusteranalyse, Clusteranalyseverfahren, Clusteringverfahren und Clusterverfahren werden nachfolgend als Synonyme verwendet.

Durch das Abbilden der Sensordatenpunkte in den Pixelraum und das Nachbilden des Clusterverfahrens durch Pixeloperationen kann nicht nur ein Ergebnis des Clusterverfahrens schneller dargestellt werden, sondern das nachgebildete Clusterverfahren als solches kann schneller ausgeführt werden. Aufwändige Berechnungen der Cluster entsprechend dem tatsächlichen Clustering-Algorithmus werden durch graphische beziehungsweise visuelle Verfahren angenähert und ersetzt. Operationen im Pixelraum können durch leistungsstarke Hardware, wie beispielsweise Graphikkarten, sowie zeitoptimierte Algorithmen durchgeführt werden.

Ein Sensordatenpunkt umfasst mindestens zwei Kenngrößen, auch kurz als Größen bezeichnet, eines Gerätes, wie beispielsweise Leistung, Geschwindigkeit, Spannung, Strom, Drehzahl, Drehmoment, aber auch Stückzahl, Qualität, Anzahl oder Dauer, zu einem beispielsweise Zeitpunkt oder bei einem bestimmten Betriebsmodus eines Geräts oder einer Anlagenkomponente. In einem Datenraum liegen Sensordaten als Werte ohne sonstigen Bezug vor. Ein Pixeldatenpunkt in einem Pixelraum bezeichnet einen Bildpunkt, auch als Pixel bezeichnet, der einem Sensordatenpunkt zugeordnet ist. Eine Vielzahl von Pixel wiederum spannt einen Pixelraum, im zweidimensionalen Fall beispielsweise Bildpunkte einer visuellen Ausgabeeinheit, beispielsweise einem Bildschirm oder Display, auf.

In einer vorteilhaften Ausführungsform wird nach Ausgabe des Clusterergebnisses mindestens einer der Parameterwerte geändert und die Verfahrensschritte c), d) und e) werden mit dem mindestens einen geänderten Parameterwert erneut durchgeführt.

Dies hat den Vorteil Clusterergebnisse mit veränderten Parametern kurzfristig visualisieren, also bildlich berechnen und darstellen zu können. Eine solche zeitoptimierte Berechnung und Darstellung von Clusterergebnissen mit unterschiedlichen Parametern erlaubt ein einfaches Erkennen von Auswirkungen der Parameteränderung auf die resultierenden Clusterergebnisse. Ein Nutzer lernt somit den Clustering-Algorithmus zu verstehen, ohne ein tieferes Verständnis der technischen Implementierung haben zu müssen. Somit ist eine Parametereinstellung des eigentlichen dichtebasierten Clusterverfahrens angepasst an die technischen Gegebenheiten und ein Domänenwissen eines Fachmanns möglich.

In einer vorteilhaften Ausführungsform wird der Pixelraum durch ein zweidimensionales Koordinatensystem aufgespannt, wobei jeder Koordinate eine unterschiedliche Größe der Sensordatenpunkte zugeordnet ist.

In einem zweidimensionalen Pixelraum können vorzugsweise Größen, die eine Abhängigkeit voneinander aufweisen, einander gegenübergestellt werden. Beispiele von Größen, die den beiden Koordinaten zugeordnet sind, sind beispielsweise Leistung und Geschwindigkeit, Intensität und Verschleiß, Umsatz und Gewinn, Anzahl und Dauer. Bevorzugt sind auch Messgrößen, die miteinander multipliziert physikalisch eine Leistung ergeben, wie beispielsweise Spannung und Strom, Drehzahl und Drehmoment oder auch Durchfluss und Druck, um beispielsweise Regionen gleicher Leistung zu ermitteln. Bevorzugt sind auch Größen wie Werkzeugnummer oder Maximalstrom beziehungsweise Druck, die von einer weiteren gemeinsamen charakteristischen Größe abhängen, so dass sich klare Gruppen ergeben.

Die Bezeichnungen Cluster und Gruppe werden in diesem Dokument als Synonym verwendet und bezeichnet eine Ähnlichkeitsstruktur von ähnlichen Objekten.

In einer vorteilhaften Ausführungsform entspricht das Verhältnis der Ausdehnung der beiden Koordinaten zueinander jeweils dem Verhältnis der Wertebereiche der zugeordneten Größe der Sensordatenpunkte zueinander, wobei insbesondere zumindest ein Wertebereich normalisierte Sensordatenwerte umfasst, oder mindestens ein Wertbereich Sensordatenwerte entsprechend einer Verteilungsfunktion umfasst.

Dies erlaubt eine intuitive Darstellung. Durch eine Normalisierung der Sensordatenwerte und anschließende Zuordnung zu einer Koordinate wird ein Fehler bei einer anschließenden Clusterbildung reduziert. Bei einer ungleichmäßigen Verteilung der Datenpunkte kann durch die Anordnung der Datenpunkte gemäß einer Verteilungsfunktion eine gleichmäßigere Verteilung der Datenpunkte auf die Pixel erreicht werden.

In einer vorteilhaften Ausführungsform ist das Clusterverfahren ein dichtebasiertes räumliches Clusteranalyseverfahren mit Rauschen, das auch abgekürzt als DBSCAN bezeichnet wird.

Dies hat den Vorteil, dass ein sehr häufig verwendetes Clusteranalyseverfahren zeitoptimiert approximiert wird.

In einer vorteilhaften Ausführungsform ist ein Distanzwert ein erster Parameter des Clusterverfahrens und die minimale Anzahl von Sensordatenpunkten um ein Cluster zu bilden, ein zweiter Parameter des Clusterverfahrens.

Dies ermöglicht es, die Hauptparameter von dichtebasierten Clusteranalyseverfahren über das visuelle Verfahren zeitoptimiert anzuwenden, ein daraus resultierendes Clusterergebnis anzuzeigen und analysieren zu können.

In einer vorteilhaften Ausführungsform ist eine Ermittlung von Kernpunkten aus der Vielzahl von Sensordatenpunkten eine erste Operation des dichtebasierten Clusterverfahrens im Datenraum und diese erste Operation wird auf eine erste Pixeloperation im Pixelraum abgebildet, wobei die erste Pixeloperation für jeden Sensordatenpunkt, dem ein betrachteter Pixeldatenpunkt zugeordnet ist, überprüft, ob die Anzahl der Pixeldatenpunkte, die innerhalb eines Distanzwertes entsprechend des ersten empfangenen Parameterwerts um den betrachteten Pixeldatenpunkt angeordnet sind, gleich dem zweiten empfangenen oder größer als der zweite empfangene Parameterwert ist.

Durch das Ersetzen der ersten Operation des dichtebasierten Clusterverfahrens durch eine erste Pixeloperation im Pixelraum können graphische Verfahren zur Berechnung und Darstellung des Clusterergebnisses verwendet werden. Diese erfordern eine geringere Anzahl an Rechenschritten, skalieren beispielsweise lediglich linear statt quadratisch, und ermöglichen damit eine Durchführung in Echtzeit.

In einer vorteilhaften Ausführungsform wird die Anzahl der Pixeldatenpunkte innerhalb eines Distanzwertes entsprechend dem ersten empfangenen Parameter um den betrachteten Pixeldatenpunkt durch das Ermitteln aller Pixeldatenpunkte, die innerhalb eines Strukturelements angeordnet sind, ermittelt, wobei das Strukturelement zentriert um den betrachteten Pixeldatenpunkt angeordnet ist und die räumliche Ausdehnung des Strukturelements abhängig vom ersten empfangenen Parameterwert ist.

Durch die Verwendung eines Strukturelements kann die Pixeldatenoperation zur Ermittlung eines Kernpunktes sehr effizient durch die Verwendung von Operationen aus der Bildverarbeitung durchgeführt werden.

In einer vorteilhaften Ausführungsform ist eine Form des Strukturelements abhängig von einem in dem Clusterverfahren verwendeten Distanzmaß, insbesondere ist das Strukturelement für ein euklidisches Distanzmaß rund, das Strukturelement für ein Manhatten-Distanzmaß rautenförmig und das Strukturelement für ein Chebyshev-Distanzmaß quadratisch.

Dies hat den Vorteil, dass die Ermittlung von Kernpunkten und damit von Clustern im Pixelraum flexibel auf ein im dichtebasierten Clusterverfahren verwendetes Distanzmaß angepasst werden kann. Durch die unterschiedliche Form des Strukturelements werden die unterschiedlichen Distanzmaße approximiert.

In einer vorteilhaften Ausführungsform wird jeder Pixeldatenpunkt im Pixelraum abhängig von einer minimalen Distanz des Pixeldatenpunktes zu einem nächsten Kernpunkt in einer Farbe dargestellt.

Dies hat den Vorteil, dass nicht nur die Zugehörigkeit zu einem Cluster, sondern die räumliche Nähe bzw. der Abstand eines Pixeldatenpunktes zu einem Kernpunkt dargestellt wird. Dadurch kann noch deutlicher die Dichteverteilung der Sensordatenpunkte sichtbar gemacht werden und bei einer Analyse des visuell dargestellten Clusterergebnisses mindestens einer der Parameter entsprechend angepasst werden.

In einer vorteilhaften Ausführungsform wird eine Kontur eines Clusters angezeigt, in dem die Pixeldatenpunkte, die einen Abstand von einer Hälfte des ersten Parameterwertes, bevorzugt zusätzlich die Pixeldatenpunkte, die einen Abstand von einem Ganzen ersten Parameterwert von einem am nächsten gelegenen Kernpunkt aufweisen, farblich dargestellt werden.

Durch eine solche Kontur werden ermittelte Gruppen oder Cluster deutlich erkennbar und trennscharf voneinander abgegrenzt. Eine solche Kontur zeigt somit Datenpunkte gleichen Abstands von "äußeren" Kernpunkten des ermittelten Clusters an und werden auch als Isokontur bezeichnet. Eine weitere Isokontur mit dem Abstandswert von einem halben Parameterwert gibt eine mögliche weitere Trennlinie zwischen Clusterpunkten und beispielsweise als Rauschen beziehungsweise anormal angesehene Pixeldatenpunkte an. Durch eine Darstellung der Konturlinien kann insbesondere deutlich ein Einfluss von geänderten Parameterwerten auf die ermittelten Cluster sichtbar und somit für einen Nutzer auswertbar gemacht werden. Alle Pixeldatenpunkte außerhalb dieser beiden Konturen, die einem Sensordatenpunkt entsprechen, werden als Rauschen beziehungsweise anormal angesehen und separat in einer von den umliegenden Pixeln, denen kein Sensordatenpunkt zugeordnet ist, unterscheidbaren Farbe dargestellt.

In einer vorteilhaften Ausführungsform werden die Pixel, entsprechend einer Schummerung abhängig von einer räumlichen Verteilung der Kernpunkte im Pixelraum dargestellt. Die Schummerung erfolgt anhand der Beleuchtung mit einer imaginären Lichtquelle.

Dies hat den Vorteil, die Positionierung einzelner Pixeldatenpunkte in der Nähe von Clustergrenzen besser beurteilen zu können. Insbesondere kann ein Benutzer selbst den Grad des 3D-Effekts einstellen oder ihn automatisch anhand der relativen Anzahl von Datenpunkten in der Nähe der Kontur oder weiterer Kennwerte einstellen lassen.

In einer vorteilhaften Ausführungsform wird für mehr als zweidimensionale Sensordatenpunkte ein zweidimensionales Verfahren mit zwei vorgebbaren Größen zu einem ausgewählten Datenwert einer dritten Größe der Sensordatenpunkte durchgeführt und über eine Änderung des ausgewählten Datenwertes der dritten Größe eine Änderung des Clusterergebnisses des zweidimensionalen Verfahrens dargestellt.

Dies erlaubt es, eine dritte Größe in die graphische Berechnung und visuelle Darstellung des Clusterergebnisses einzubeziehen. Durch eine beispielsweise kontinuierliche, schrittweise Änderung der dritten Größe und entsprechenden kontinuierlichen Darstellung der entsprechenden Clusterergebnisse kann die Veränderung der Cluster abhängig von dieser dritten Größe sichtbar und somit von einem Nutzer beziehungsweise Experten analysiert und mindestens ein Parameterwert der eingegebenen ersten und zweiten Parameter angepasst werden. Die dritte Größe, die einer dritten Datendimension entspricht, kann somit durch eine Animation der zweidimensionalen Sensordaten anhand einer dritten Dimension dargestellt werden. Für eine gute Interpretierbarkeit durch einen Experten werden Zeitschritte oder Betriebszustände als dritte Dimension empfohlen.

Ein zweiter Aspekt der Erfindung betrifft eine Assistenzvorrichtung, das eine Parametrisierung eines Anomalieerkennungsverfahrens, insbesondere ausgeführt in einer Anomalieerkennungsvorrichtung (90), basierend auf einer Vielzahl von Sensordatenpunkten mittels eines dichtebasierten Clusterverfahrens durchführt, umfassend
a) eine Abbildungseinheit, die derart ausgebildet ist, jeden Sensordatenpunkt in einen Pixeldatenpunkt in einen Pixelraum zu übertragen,
b) eine Nachbildeeinheit, die derart ausgebildet ist, mindestens eine Operation des dichtebasierten Clusterverfahrens im Datenraum durch mindestens eine Pixeloperation im Pixelraum nachzubilden,
c) eine Eingabeeinheit, die derart ausgebildet ist, mindestens einen Parameterwert für jeden Parameter des dichtebasierten Clusterverfahrens zu empfangen,
d) eine Operationseinheit, die derart ausgebildet ist, mindestens eine Pixeloperation entsprechend den Parameterwerten auf die Pixeldatenpunkte anzuwenden,
e) eine Ausgabeeinheit, die derart ausgebildet ist, Clusterergebnisse im Pixelraum in visueller Form darzustellen, und
f) eine Bereitstellungseinheit, die derart ausgebildet ist, die empfangenen Parameterwerte als Eingangsparameter für das Anomalieerkennungsverfahren bereitzustellen.

Eine solche Assistenzvorrichtung, die mindestens einen Prozessor umfasst, ermöglicht es das Clusterergebnis nicht mehr im ursprünglichen Datenraum, sondern in einem Pixelraum zu berechnen. Die Laufzeit zur Berechnung des Clusterergebnisses ist somit nicht mehr abhängig von der Anzahl der Datenpunkte, sondern der Anzahl der Pixel, also der Auflösung der Visualisierung, sowie der gewählten Parameterwerte. Über die Wahl der Anzahl der Pixel kann zwischen Auflösung und Rechenzeit abgewogen werden. Dies kann den Ansatz speziell für große Datensätze enorm beschleunigen. Somit ist eine Berechnung von Clusterergebnissen in Echtzeit möglich.

In einer vorteilhaften Ausführungsform ist der Pixelraum durch eine Vielzahl von Pixeln mindestens eines Teilbereichs der Ausgabeeinheit, insbesondere eines Bildschirms, ausgebildet.

Ein Pixel bezeichnet einen Bildpunkt einer visuellen Ausgabeeinheit. Ein Pixel kann aber auch eine Gruppe von physikalischen Bildpunkten sein, wenn die Auflösung der Eingabeeinheit größer als die Auflösung der Pixeldatenpunkte im Pixelraum ist.

In einer vorteilhaften Ausführungsform sind die Eingabeeinheit und die Ausgabeeinheit als eine graphische Nutzerschnittstelle ausgebildet, die derart ausgebildet ist, ein graphisches Eingabeelement für mindestens einen Parameter darzustellen und darüber den entsprechenden Parameterwert auszuwählen und zu empfangen.

Dies ermöglicht eine einfache und intuitive Änderungs- beziehungsweise Eingabemöglichkeit der Parameter, die insbesondere bei gleichzeitiger Darstellung des Clusterergebnisses einen Zusammenhang zwischen den empfangenen Parametern und dem Clusterergebnis erfassbar macht.

In einem dritten Aspekt betrifft die Erfindung ein Computerprogrammprodukt umfassend ein nicht vorübergehendes computer-lesbares Medium, das direkt in einen Speicher eines digitalen Computers ladbar ist, umfassend Programmcodeteile, die dazu geeignet sind, die Schritte des beschriebenen Verfahrens durchzuführen.

Sofern es in der nachfolgenden Beschreibung nicht anders angegeben ist, beziehen sich die Begriffe "abbilden", "nachbilden", "empfangen", "anwenden", "ausgeben", "bereitstellen" und dergleichen vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt oder vorliegen können.

Unter einem Prozessor kann im Zusammenhang mit der Erfindung beispielsweise ein Computer, eine Maschine oder eine elektronische Schaltung verstanden werden. Auch kann unter einem Prozessor ein virtualisierter Prozessor, der beispielsweise in einem durch viele Nutzer geteilten Server, auch als Cloud bezeichnet, ausgebildet sein. Eine jeweilige "Einheit", zum Beispiel die Abbildungseinheit oder Nachbildeeinheit, kann hardwaretechnisch und/oder auch softwaretechnisch implementiert sein. Bei einer hardwaretechnischen Implementierung kann die jeweilige Einheit als Vorrichtung oder als Teil einer Vorrichtung zum Beispiel als Computer, als Teil eines Computers wie beispielsweise eine Graphikkarte oder als Mikroprozessor ausgebildet sein. Bei einer softwaretechnischen Implementierung kann die jeweilige Einheit als Computerprogrammprodukt, als eine Funktion, als eine Routine, als Teil eines Programmcodes oder als ausführbares Objekt ausgebildet sein.

Ein Computerprogrammprodukt kann beispielsweise als Speichermedium, wie zum Beispiel eine Speicherkarte, USB-Stick, CD-ROM, DVD oder auch in Form einer herunterladbaren Datei von einem Server in einem Netzwerk bereitgestellt oder geliefert werden.

Ausführungsbeispiele des erfindungsgemäßen Verfahrens sowie der Assistenzvorrichtung sind in den Zeichnungen beispielhaft dargestellt und werden anhand der nachfolgenden Beschreibung näher erläutert. Es zeigen:
- Figur 1: ein Ausführungsbeispiel des erfindungsgemäßen Verfahrens als Flussdiagramm;
- Figur 2: eine schematische Darstellung von Parametern eines dichtebasierten Clusterverfahrens;
- Figur 3: eine schematische Darstellung der Abbildung von Sensordatenpunkten in einem dreidimensionalen Datenraum in Pixeldatenpunkte eines zweidimensionalen Pixelraums;
- Figur 4: eine schematische Darstellung zur Ausdehnung und Einteilung einer Koordinate entsprechend einer Verteilungsfunktion der Sensordatenwerte;
- Figur 5: eine schematische Darstellung der erfindungsgemäßen ersten Pixeloperation;
- Figur 6: ein Ausführungsbeispiel eines durch das erfindungsgemäße Verfahren ausgegebenen Clusterergebnisses in visueller Form im Pixelraum;
- Figur 7: ein Ausführungsbeispiel einer erfindungsgemäßen Assistenzvorrichtung in Blockdarstellung; und
- Figur 8: ein Ausführungsbeispiel einer erfindungsgemäßen Ausgabeeinheit mit graphischen Parametereingabeelementen in schematischer Darstellung.

Einander entsprechende Teile sind in allen Figuren mit den gleichen Bezugszeichen versehen.

Um eine datenbasierte Anomalieerkennung, beispielsweise für eine industrielle Anlage beziehungsweise ein technisches Gerät durchzuführen, ist eine Auswahl von Eingabeparametern, die einen Cluster charakterisieren, in ein Clusterverfahren notwendig. Die Parameter können beispielsweise in eine Anomalieerkennungsvorrichtung eingegeben werden und die zu untersuchenden Sensordaten entsprechend den eingegebenen Parametern Cluster von Sensordatenpunkten ermittelt und das Ergebnis des Clusterverfahrens ausgegeben werden. Erst anhand des Clusterergebnisses kann abgeschätzt werden, ob die eingegebenen Parameter zu einem für den Anwendungsbereich sinnvollen Clusterergebnis führen. Ein erneutes Durchführen der Clusteranalyse mit geänderten Parametern ist somit mehrfach notwendig. Da die Zeit zur Ermittlung eines Clusterergebnisses, insbesondere bei einer großen Datenmenge zeitaufwändig ist, können die Parameter für das Clusterverfahren durch das nachfolgende Verfahren zeitoptimiert und bereits unter Einbeziehung von Expertenwissen ermittelt werden.

Dabei wird die Funktionsweise eines dichtebasierten Clusterverfahrens durch eine interaktive Visualisierung nachempfunden. Dies erfolgt annähernd in Echtzeit. Ein Benutzer interagiert also nicht mehr mit dem langsamen dichtebasierten Clusterverfahren, das eine Berechnung von Clustern anhand von Sensordatenpunkten in einem Datenraum durchführt, sondern direkt mit einem interaktiven, visuell dargestellten und mit Datenverarbeitungsmethoden aus dem Bildverarbeitungsbereich durchgeführten Verfahren, das eine Auswirkung von Parameter-ändern in einem dichtebasierten Clusterverfahren direkt und in Echtzeit approximiert.

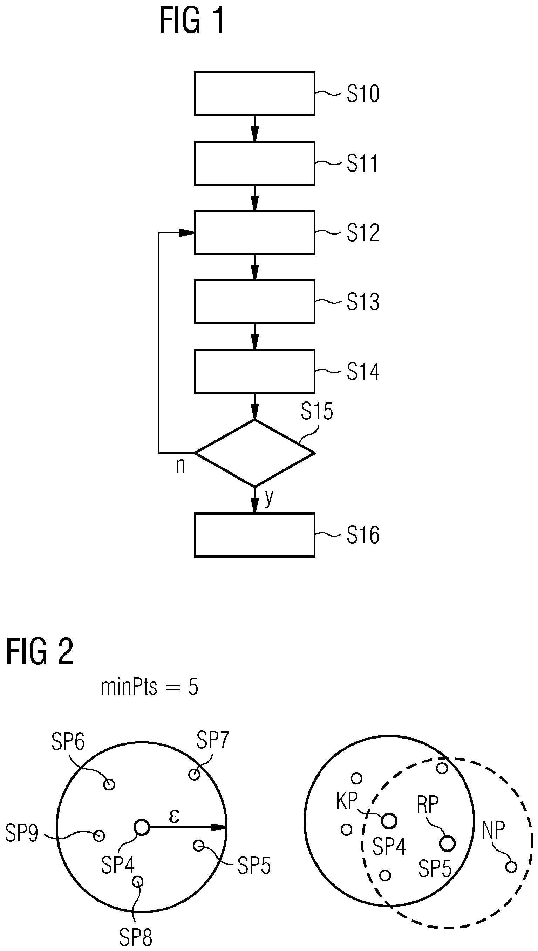

Dem Clusterverfahren liegen eine, insbesondere große, Anzahl von Datenpunkten, insbesondere Sensordatenpunkten, vor, für die ein Zusammenhang in Form einer Dichteverteilung von Datenpunkten in Gruppen, sogenannte Cluster, ermittelt werden soll. Figur 1 zeigt das Verfahren als Flussdiagramm. In einem ersten Verfahrensschritt S10 wird ein jeder Sensordatenpunkt in einem Datenraum in einen Pixeldatenpunkt in einem Pixelraum abgebildet.

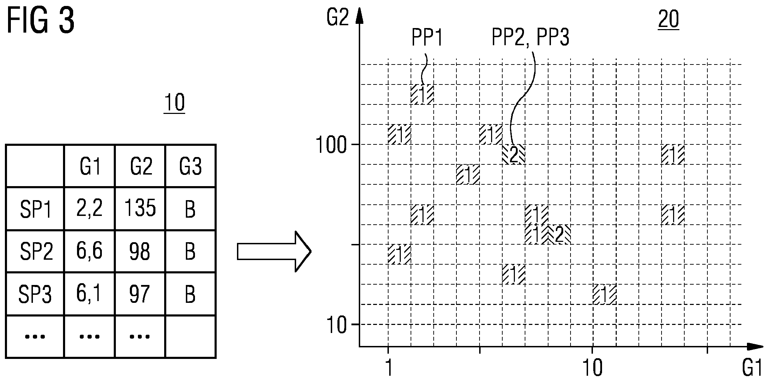

Figur 3 zeigt beispielhaft für einen dreidimensionalen Datenraum 10 Sensordatenpunkte SP1, SP2, SP3, die jeweils einen Wert für eine jeweils unterschiedliche Größe G1, G2, G3 aufweisen. Die Größe G1 könnte beispielsweise die Leistung, die Größe G2 beispielsweise die Geschwindigkeit angeben. G3 könnte eine vorbestimmte Zeit oder ein Betriebsmodus sein. Die Sensordatenpunkte werden hier in ein zweidimensionales Koordinatensystem mit den Ausdehnungen eines Pixelraums 20, beispielsweise von Bildpunkten einer visuellen Ausgabeeinheit, wie beispielsweise einem Bildschirm, abgebildet. Die Abbildung wird durch den Pfeil symbolisiert. Dazu werden alle Datenpunkte der Größen G1, G2 bei einem festen Wert der Größe G3, beispielsweise dem Wert B für die Clusteranalyse berücksichtigt. So wird beispielsweise der Sensordatenpunkt SP1 im Datenraum 10 auf einen Pixeldatenpunkt PP1 im Pixelraum 20 abgebildet. Entsprechend wird der Sensordatenpunkt SP2 auf den Pixeldatenpunkt PP2 abgebildet. Der Sensordatenpunkt SP3 wird auf den Pixeldatenpunkt PP3 abgebildet, der mit dem Pixeldatenpunkt PP2 zusammenfällt, da die Auflösung des Pixeldatenraums 20 keinen separaten Pixel für diesen Wert bereithält.

Das Verhältnis der Ausdehnung des Pixelraums 20, das heißt das Verhältnis der Koordinaten für die Größen G1 und G2 ist im gezeigten Beispiel gleich dem Verhältnis der Wertebereiche der Eingangsdaten. Im Idealfall ist die Skalierung der beiden Koordinaten identisch. Je größer die Abweichung der Skalierung ist, desto größer ist der Fehler bei einer anschließenden Ermittlung der Cluster. Daher ist bei großen Unterschieden der Wertebereiche vorab eine Normalisierung der Sensordatenpunkte vorzunehmen. Die Ermittlung der Cluster sollte dann auch auf die normalisierten Datenpunkte durchgeführt werden. Für jeden Pixel im Pixelraum 20 wird die Anzahl von Sensordatenpunkten berechnet, die auf diese Pixelpositionen abgebildet werden. Für die Pixelpositionen des Pixeldatenpunktes PP2 ist daher die Anzahl der darauf projizierten Sensordatenpunkte, hier also der Wert 2, vermerkt.

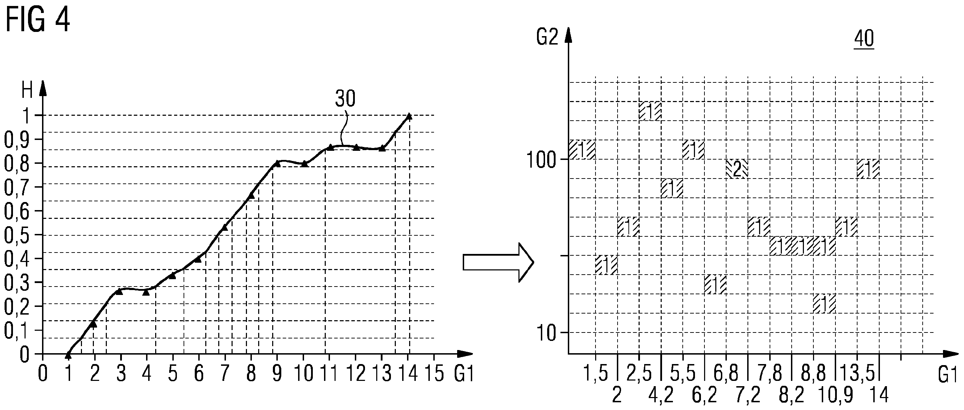

Um eine besonders gute Auflösung der Pixeldatenpunkte bei sehr unterschiedlicher Dichteverteilung der Sensordatenpunkte zu erreichen, kann ein Wertebereich von Sensordatenwerten entsprechend einer Verteilungsfunktion 30 eingeteilt werden. Figur 4 zeigt auf der linken Seite eine solche Verteilungsfunktion 30, bei der die Häufigkeit H, mit der ein Wert der Größe G1 vorhanden ist, über den Wertebereich der Größe G1 aufgetragen ist. Auf der rechten Seite von Figur 4 ist die Koordinate der Größe G1 des Pixelraums 40 entsprechend der Verteilungsfunktion 30 skaliert. Dabei werden die Abstände zwischen jeweils zwei blau markierten Werten von G1 auf gleiche Abstände der Koordinate G1 im Pixelraum 40 überführt. Dies hat jedoch den Nachteil, dass eine darauf basierte Clusterbestimmung von der üblichen Verteilung der Datenpunkte und somit von der üblichen bekannten Darstellung für den Domänenexperten abweicht. Eine Interpretation des Clusterergebnisses wird somit eventuell erschwert.

Im nächsten Verfahrensschritt S11, siehe Figur 1, wird nun mindestens eine Operation des dichtebasierten Clusterverfahrens im Datenraum durch mindestens eine Pixeloperation im Pixelraum nachgebildet. Ein sehr häufig verwendetes dichtebasiertes Clusterverfahren ist ein so genanntes dichtebasiertes räumliches Clusteranalyseverfahren mit Rauschen, kurz auch als DBSCAN bezeichnet. Dieses Clusterverfahren wird über zwei Parameter, einen Distanzwert ε sowie einen Schwellwert für die minimale Anzahl von Datenpunkten (minPts), die eine Gruppe beziehungsweise ein Cluster darstellen, gesteuert.

In Figur 2 sind diese Parameter und weitere Kenngrößen zur Clusterermittlung des DBSCAN-Clusterverfahrens schematisch dargestellt. Um eine dichte Region im Datenraum, also ein Cluster zu finden, wird für jeden Sensordatenpunkt SP4 überprüft, wie viele andere Sensordatenpunkte in einem Abstand kleiner dem vorgegebenen Distanzwert ε vorhanden sind. Im linken Bereich von Figur 2 sind mehrere Sensordatenpunkte Sp4- SP9 durch Punkte dargestellt, der betrachtete Sensordatenpunkt SP4 ist mit einer stärkeren Kontur markiert. Der Pfeil zeigt einen Abstand ε, der dem vorgegebenen ersten Parameter entspricht und eine Distanz angibt. Ist die Anzahl der Sensordatenpunkte in der Umgebung des betrachteten Sensorpunktes SP4 gleich oder größer als der vorgegebene zweite Parameter minPts, der einen Schwellwert für die Anzahl der benachbarten Datenpunkte angibt, so ist der betrachtete Sensordatenpunkt SP4 ein Kernpunkt eines Clusters. Ist der Schwellwert beispielsweise auf die Anzahl von fünf Datenpunkten festgelegt, so ist der Sensordatenpunkt SP4 ein Kernpunkt KP. Alle Sensordatenpunkte, welche selbst nicht Kernpunkte sind, die jedoch innerhalb der Distanz ε zu einem existierenden Kernpunkt liegen, werden als Randpunkte bezeichnet. Der Sensordatenpunkt SP5 auf der rechten Seite von Figur 2 ist beispielsweise ein Randpunkt, da er einen geringeren Abstand als die vorgegebene Distanz ε zum Kernpunkt SP4 aufweist, selbst aber kein Kernpunkt ist, da lediglich vier Datenpunkte in einem Abstand ε liegen. Ein Punkt NP wird als Rauschpunkt bezeichnet, wenn er einen größeren Abstand als der vorgegebene erste Parameter ε zum nächsten Kernpunkt aufweist.

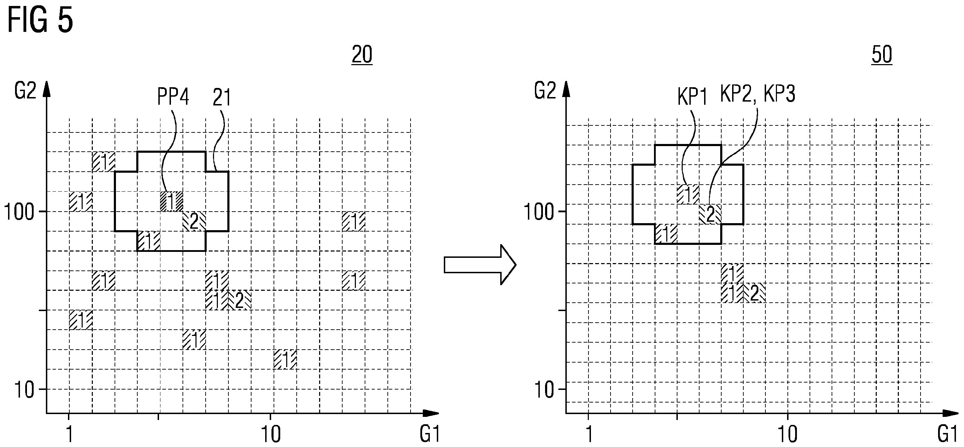

Das Bestimmen von Kernpunkten und Clustern wird nun im Pixelraum durch eine Pixeloperation nachgebildet. Figur 5 zeigt auf der linken Seite die aus Figur 3 bekannte Darstellung der Sensordatenwerte in einem Pixelraum 20. Die Darstellung entspricht einem zweidimensionalen Histogramm, das zusätzlich zu jedem Pixel die Anzahl der Sensordatenpunkte, die durch den gleichen Pixel dargestellt werden, umfasst. Die vorher beschriebene erste Operation des dichtebasierten Clusterverfahrens im Datenraum wird nun auf eine erste Pixeloperation im Pixelraum abgebildet. Die erste Pixeloperation überprüft für jeden Sensordatenpunkt, dem ein betrachteter Pixeldatenpunkt PP4 zugeordnet ist, ob die Anzahl der Pixeldatenpunkte, die innerhalb eines Distanzwertes ε entsprechend einem ersten Parameterwert um den betrachteten Pixeldatenpunkt PP4 angeordnet sind, größer als der zweite Parameterwert, nämlich die minimale Anzahl von Datenpunkten minPts in einem Cluster ist.

In einer Implementierung dieser Operation wird beispielsweise für jeden Eintrag im 2D-Histogramm, siehe Pixelraum 20 der einen Wert ungleich Null aufweist, überprüft, ob die Anzahl der Pixeldatenpunkte innerhalb der Distanz ε größer dem Schwellwert der Anzahl von Punkten minPts ist. Dazu wird beispielsweise der Pixeldatenpunkt PP4 als betrachteter Pixeldatenpunkt untersucht, indem ein Strukturelement 21 der Ausdehnung entsprechend dem ersten Parameter ε verwendet wird. Ist dies erfüllt, wird der Punkt PP4 als Kernpunkt KP in eine separate Ergebnismatrix 50, siehe rechte Seite von Figur 5, gespeichert. Das Fallen eines Pixeldatenpunkts in ein Strukturelement 21 kann durch günstige Implementierung zeitoptimiert überprüft werden. Insbesondere eine Implementierung durch Zählen der Anzahl von Datenpunkten in der Nachbarschaft zu einem betrachteten Pixeldatenpunkt PP4 aus dem 2D-Histogramm 20 ermöglicht eine schnelle Implementierungsausführung.

Im nächsten Verfahrensschritt S12 des erfindungsgemäßen Verfahrens, siehe Figur 1, werden nun mindestens ein Parameterwert für jeden Parameter des dichtebasierten Clusterverfahrens empfangen. Somit sind nun für den bereits beschriebenen Vorgang die Größe des Strukturelements ε sowie der Schwellwert für die Anzahl von Pixeldatenpunkten minPts, die ein Cluster bilden, festgelegt. Als ein weiterer Parameter kann ein Distanzmaß, das im Clusterverfahren angewandt werden soll, festgelegt werden. Entsprechend einem solchen Distanzmaß wird ein unterschiedliches Strukturelement 21 in der Pixeloperation verwendet. Für ein euklidisches Distanzmaß wird ein rundes Strukturelement 21 verwendet. Für ein Manhatten-Distanzmaß wird ein rautenförmiges Strukturelement, für ein Chebyshev-Distanzmaß wird ein quadratisches Distanzmaß verwendet. Die beschriebene Pixeloperation wird nun in Verfahrensschritt S13, siehe Figur 1, entsprechend den empfangenen Parameterwerten auf die Pixeldaten angewendet und in Schritt S14 das Clusterergebnis in visueller Form im Pixelraum ausgegeben.

Für das Ausgeben (S14) der Clusterergebnisse wird nach dem Ermitteln der Kernpunkte KP1, KP2, KP3 der Cluster für jedes Pixel im Pixelraum 20 die minimale Distanz zum nächsten Kernpunkt KB aus der Ergebnismatrix 50 berechnet. Ein resultierendes Distanzfeld kann sehr effizient beispielsweise durch einen Algorithmus von Meijster et al. berechnet werden, der in "A General Algorithm for Computing Distance Transforms in Linear Time," in Mathematical Morphology and its Applications to Image and Signal Processing, Seiten 331-340, Springer, 2000, beschrieben ist. Für eine visuelle Darstellung wird die berechnete minimale Distanz zu den Kernpunkten aus dem Distanzfeld in Farbe abgebildet. Somit wird jeder Pixeldatenpunkt im Pixelraum abhängig von einer minimalen Distanz zu einem nächsten Kernpunkt in einer unterschiedlichen Farbe dargestellt. Bevorzugt wird eine divergierende Farbpalette verwendet und abhängig vom Abstand eines Pixels vom nächsten Kernpunkt die Pixelfarbe entsprechend einem Farbgradienten unterschiedlich gewählt. Die Kernpunkte selbst werden im Ergebnis nicht mehr separat dargestellt und sind durch die Farbpalette erkennbar. Die Farbpalette wird für das gesamte Ergebnisbild bevorzugt einheitlich definiert.

Um den Rand beziehungsweise die Grenzen eines Clusters deutlich erkennen zu können, wird eine Eingrenzung berechnet und eingezeichnet. Hierfür werden Isokonturen auf dem Distanzfeld für einen Abstand von einem Ganzen des ersten Parameterwertes ε und bevorzugt eine weitere Isokontur mit dem Abstand von der Hälfte des ersten Parameterwertes ε/2 berechnet. Ein Benutzer kann somit zwischen Kernpunkten, die innerhalb der Isokontur mit einem Abstand von der Hälfte des ersten Parameterwertes ε/2 liegen und Randpunkten des Clusters unterscheiden. Alle Punkte, die also durch eine Abbildung eines Sensordatenpunktes definiert sind, die außerhalb dieser beiden Konturen liegen, werden als Rauschen beziehungsweise anormal angesehen und bevorzugt in einer Farbe, die sich von den sonstigen Pixeln unterscheidet, separat dargestellt.

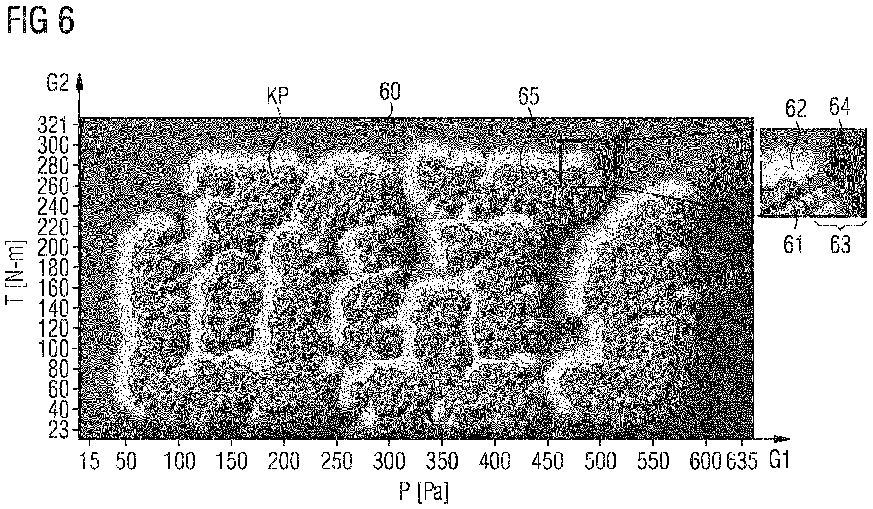

Eine visuelle Darstellung 60 des Clusterergebnisses ist in Figur 6 dargestellt. In einer farblichen Darstellung ist beispielsweise ein Kernpunkt KP in grüner Farbe dargestellt, die Pixel entsprechend ihrem Abstand zum nächsten Kernpunkt, werden beispielsweise in einer graduellen Farbskala von grün nach weiß dargestellt.

Im rechts neben der visuellen Darstellung des Clusterergebnisses 60 dargestellten Ausschnitt ist ein Bereich eines Cluster 65 vergrößert dargestellt. Der farbliche Verlauf außerhalb des Clusters 65, siehe Bereich 63, zeigt eine Schummerung, die abhängig von einer räumlichen Verteilung der Kernpunkte im Pixelraum dargestellt wird. Die Kontur 61 mit einem Abstand und einem halben empfangenen Parameterwert ε/2 ist dabei deutlicher sichtbar als die Isokontur 62, die einen Abstand eines ganzen ersten Parameterwerts ε angibt. Rauschpunkte 64 sind wiederum farblich abgehoben dargestellt.

Liegen auf beiden Seiten nahe der Kontur 61 ähnlich viele Pixeldatenpunkte vor, ist ein besonders starker Höheneffekt erzeugt durch die Schummerung wünschenswert. Dadurch wird die Zuverlässigkeit der Grenze verdeutlicht. Ist der Unterschied der Anzahl der Pixeldatenpunkte auf beiden Seiten der Kontur hoch, kann die Unsicherheit der Kontur an dieser Stelle durch einen schwächeren Höheneffekt verdeutlicht werden. Ebenfalls wird ein Genauigkeitswert für die Zuverlässigkeit angegeben

Nach einer Ausgabe des Clusterergebnisses kann mindestens einer der Parameterwerte, bevorzugt über eine graphische Nutzerschnittstelle geändert werden, siehe Verfahrensschritt S15 in Figur 1. Ist dies der Fall, wird der geänderte Parameterwert im Verfahrensschritt S12 im Verfahren empfangen und die Verfahrensschritte des Anwendens S13 der Pixeloperation erneut durchgeführt und ein Clusterergebnis basierend auf den geänderten Parameterwerten ausgegeben, siehe Verfahrensschritt S15. Diese wiederholte Anwendung der Pixeloperationen ist durch den Pfeil n symbolisiert. Sind keine weiteren Parameteränderungen gewünscht, siehe Pfeil y, werden im Verfahrensschritt S16 die letzten empfangenen Parameterwerte ε und minPts dem Anomalieerkennungsverfahren, das das dichtebasiertes Clusterverfahren mit den Sensordatenpunkten im Datenraum beispielsweise in einer Anomalieerkennungsvorrichtung ausführt, bereitgestellt.

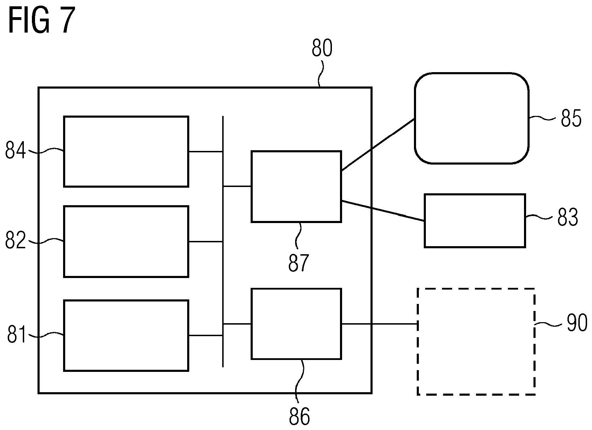

Figur 7 zeigt eine Assistenzvorrichtung 80, die das beschriebene Verfahren ausführt. Die Assistenzvorrichtung 80 umfasst eine Abbildungseinrichtung 81, die derart ausgebildet ist, jeden Sensordatenpunkt in einen Pixeldatenpunkt in einem Pixelraum zu übertragen, eine Nachbildeeinheit 82, die derart ausgebildet ist, mindestens eine Operation des dichtebasierten Clusterverfahrens im Datenraum durch mindestens eine Pixeloperation im Pixelraum nachzubilden, sowie eine Operationseinheit 84, die derart ausgebildet ist, mindestens eine Pixeloperation entsprechend den empfangenen Parameterwerten auf die Pixeldatenpunkte anzuwenden. Die Assistenzvorrichtung 80 umfasst des Weiteren eine Bereitstellungseinheit 86, die die empfangenen Parameterwerte als Eingangsparameter für ein Anomalieerkennungsverfahren im Datenraum einer Anomalieerkennungsvorrichtung 90 bereitstellt. Über diese Bereitstellungseinheit 86 kann ebenfalls die zu betrachtende gesamte Sensordatenmenge in das Assistenzsystem geladen beziehungsweise dort empfangen und gespeichert werden. Das Assistenzsystem 80 umfasst des Weiteren eine Eingabeeinheit 83 und eine visuelle Ausgabeeinheit 85, die bevorzugt als eine graphische Nutzerschnittselle ausgebildet sind.

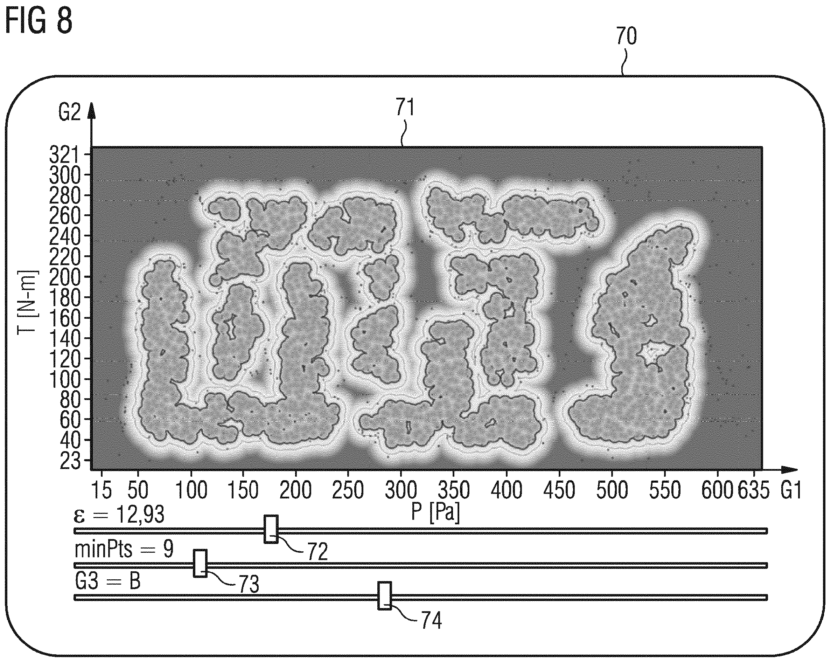

Figur 8 zeigt eine Ausgabeeinheit beziehungsweise die darauf dargestellte graphische Nutzerschnittstelle 70. In Bereich 71 ist dabei ein Clusterergebnis dargestellt. Darunter sind für den ersten und zweiten Parameter ε, minPts jeweils ein graphisches Eingabeelement 72, 73 angezeigt. Das graphische Eingabeelement 72, 73 kann beispielsweise jeweils als ein Schieberegler dargestellt sein, über den der erste und/oder der zweite Parameter ε, minPts geändert und als Eingabe für die Pixeloperation an die Operationseinheit 84 bereitgestellt werden. Eine Neuberechnung der Cluster erfolgt automatisch nach einer Parameteränderung.

Zur Erweiterung der Clusteranalyse auf mehr als zweidimensionale Sensordaten können beispielsweise Aggregationsverfahren auf zwei Dimensionen wie zum Beispiel selbstorganisierende Karten angewendet werden. Erfindungsgemäß wird eine dritte oder weitere Datendimension bzw. eine entsprechende Größe G3 durch eine Animation der zweidimensionalen Clusteranalyse anhand eines jeweils unterschiedlichen Sensordatenwertes B der dritten Größe G3 dargestellt. Hierbei kann auf eine geeignete Wahl der dritten Dimension G3 eventuell durch eine vorhergehende Aggregation mehrerer Datendimensionen Rücksicht genommen werden.

Mit einem weiteren graphischen Eingabeelement, beispielsweise einem weiteren Schieberegler 74, kann ein Datenwert der dritten Größe G3 eingegeben werden. Beispielsweise kann das Clusterverfahren für sukzessiv geänderte Werte der dritten Größe durchgeführt und die visuelle Darstellung der resultierenden Clusterergebnisse als Animation dargestellt werden. Insbesondere können für die dritte Datendimension verändernde Betriebsbedingungen wie zum Beispiel Stillstand, Hochfahren, Teillastbetrieb, Volllastbetrieb, Herunterfahren gewählt werden, so dass Vergleiche der angelernten "Gut- und Schlechtbereiche", die durch Punkte innerhalb der Cluster beziehungsweise außerhalb der Cluster gekennzeichnet sind, zwischen verschiedenen Betriebsbedingungen möglich sind. Somit werden gerade nicht die bekannten, gewollten Betriebsbedingungsänderungen als Anomalie erkannt. Veränderungen von Pixeldatenpunkten bei unterschiedlichen Betriebsbedingungen, also einer unterschiedlichen dritten Dimension von Größen, können anhand von Trajektorien beispielsweise von Kernpunkten oder ausgewählten Punkten der Konturlinien 61, 62 dargestellt werden.

Durch das beschriebene Verfahren und die beschriebene Vorrichtung können geeignete Parameterwerte für eine erste Analyse im Datenraum durch die graphische approximierte Durchführung des Clusterverfahrens in einen Pixelraum zeitoptimiert ermittelt und durch Expertenwissen vorgeprüft werden. Durch die Durchführung des Clusterverfahrens in Echtzeit und eine einfache Änderung der Parameter kann der Einfluss der Parameter auf das Clusterergebnis anschaulich dargestellt werden und auch einem Nichtexperten das Verhalten des Clusterverfahrens abhängig von den Eingabeparametern aufgezeigt werden. Somit kann das zeitaufwändige datenbasierte Clusterverfahren im Datenraum nur für voruntersuchte und sinnvoll erachtete Parameterwerte durchgeführt werden und somit zu einem zeitoptimierten Anomalieerkennungsprozess beitragen. Über ein geeignetes Abbild beziehungsweise Mapping der Größen auf den Pixelraum können Rechenzeit gegenüber Auflösung gegeneinander abgewogen werden, so dass zum Beispiel ein Anlagenbediener schnell einen groben Überblick erhält, der dann beim Auftreten von Anomalien durch einen Instandhalter mit einer längerdauernden Analyse im Detail untersucht werden kann.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt.

## Patentansprüche

1. Verfahren zur Parametrisierung eines Anomalieerkennungsverfahrens, das basierend auf einer Vielzahl von Sensordatenpunkten, ein dichtebasiertes Clusterverfahren durchführt, **gekennzeichnet durch**
a) Abbilden (S10) eines jeden Sensordatenpunkts (SP1, SP2, SP3) in einem Datenraum in einen Pixeldatenpunkt (PP1, PP2, PP3) in einem Pixelraum, der von einer Vielzahl von Pixeldatenpunkten aufgespannt wird,
b) Nachbilden (S11) mindestens einer Operation des dichtebasierten Clusterverfahrens im Datenraum durch mindestens eine Pixeloperation im Pixelraum,
c) Empfangen (S12) von mindestens einem Parameterwert für jeden Parameter des dichtebasierten Clusterverfahrens,
d) Anwenden (S13) der mindestens einen Pixeloperation entsprechend den empfangenen Parameterwerten auf die Pixeldatenpunkte (PP1, PP2, PP3),
e) Ausgeben (S14) eines Clusterergebnisses in visueller Form im Pixelraum, und
f) Bereitstellen (S16) der empfangenen Parameterwerte für das Anomalieerkennungsverfahren.

2. Verfahren nach Anspruch 1, wobei nach Ausgabe des Clusterergebnisses mindestens einer der Parameterwerte geändert wird (S15) und die Verfahrensschritte c), d) und e) mit dem mindestens einen geänderten Parameterwert erneut durchgeführt werden.

3. Verfahren nach einem der vorangehenden Ansprüche, wobei der Pixelraum durch ein zweidimensionales Koordinatensystem aufgespannt wird, wobei jeder Koordinate eine unterschiedliche Größe (G1, G2) der Sensordatenpunkte (SP1, SP2, SP3) zugeordnet ist.

4. Verfahren nach Anspruch 3, wobei das Verhältnis der Ausdehnung der beiden Koordinaten zueinander jeweils dem Verhältnis der Wertebereiche der zugeordneten Größe (G1, G2) der Sensordatenpunkte zueinander entspricht, oder mindestens ein Wertebereich normalisierte Sensordatenwerte umfasst oder mindestens ein Wertebereich Sensordatenwerte entsprechend einer Verteilungsfunktion (30) umfasst.

5. Verfahren nach einem der vorangehenden Ansprüche, wobei das Clusterverfahren ein dichtebasiertes räumliches Clusteranalyseverfahren mit Rauschen (DBSCAN) ist.

6. Verfahren nach Anspruch 5, wobei
ein Distanzwert (ε) ein erster Parameter des Clusterverfahrens und die minimale Anzahl (minPts) von Sensordatenpunkten (SP1, SP2, SP3) um ein Cluster zu bilden, ein zweiter Parameter des Clusterverfahrens ist.

7. Verfahren nach Anspruch 5 oder 6, wobei eine Ermittlung von Kernpunkten (KP) aus der Vielzahl von Sensordatenpunkten (SP1, SP2, SP3) eine erste Operation des dichtebasierten Clusterverfahrens im Datenraum ist und diese erste Operation auf eine erste Pixeloperation im Pixelraum abgebildet wird, wobei die erste Pixeloperation für jeden Sensordatenpunkt (SP1, SP2, SP3), dem ein betrachteter Pixeldatenpunkt (PP4) zugeordnet ist, überprüft, ob die Anzahl der Pixeldatenpunkte, die innerhalb eines Distanzwerts entsprechend dem ersten empfangenen Parameterwert um den betrachteten Pixeldatenpunkt (PP4) angeordnet sind, gleich dem zweiten empfangenen oder größer als der zweite empfangene Parameterwert ist.

8. Verfahren nach Anspruch 7, wobei die Anzahl der Pixeldatenpunkte innerhalb eines Distanzwerts entsprechend dem ersten empfangenen Parameter um den betrachteten Pixeldatenpunkt durch das Ermitteln aller Pixeldatenpunkte, die innerhalb eines Strukturelement (21) angeordnet sind, ermittelt wird, wobei das Strukturelement (21) zentriert um den betrachteten Pixeldatenpunkt (PP4) angeordnet ist, und die räumliche Ausdehnung des Strukturelements abhängig vom ersten empfangenen Parameterwert (ε) ist.

9. Verfahren nach Anspruch 8, wobei eine Form des Strukturelements (21) abhängig von einem in dem Clusterverfahren angewendeten Distanzmaß ist, insbesondere das Strukturelement (21) für ein Euklidisches Distanzmaß rund ist, das Strukturelement (21) für ein Manhattan Distanzmaß rautenförmig ist, das Strukturelement (21) für ein Chebyshev Distanzmaß quadratisch ist.

10. Verfahren nach einem der Ansprüche 6 bis 9, wobei jeder Pixeldatenpunkt (PP1, PP2, PP3) im Pixelraum abhängig von einer minimalen Distanz des Pixeldatenpunktes (PP1, PP2, PP3) zu einem nächsten Kernpunkt (KP) in einer Farbe dargestellt wird.

11. Verfahren nach einem der Ansprüche 6 bis 10, wobei eine Kontur (61, 62) eines Clusters anzeigt wird, indem die Pixeldatenpunkte (PP1, PP2, PP3), die einen Abstand von der Hälfte des ersten Parameterwerts (ε/2), bevorzugt zusätzlich die Pixeldatenpunkte, die einen Abstand von einem Ganzen ersten Parameterwert (ε**)** von einem am nächsten gelegenen Kernpunkt (KP) aufweisen, farblich dargestellt werden.

12. Verfahren nach einem der Ansprüche 6 bis 11, wobei die Pixel entsprechend einer Schummerung abhängig von einer räumlichen Verteilung der Kernpunkte im Pixelraum dargestellt werden.

13. Verfahren nach einem der Ansprüche 1 bis 3, wobei für mehr als zweidimensionale Sensordatenpunkte ein zweidimensionales Verfahren gemäß den Ansprüchen 4 bis 12 mit zwei vorgebbaren Größen (Dimensionen) zu einem ausgewählten Datenwert einer dritten Größe der Sensordatenpunkte durchgeführt wird und über eine Änderung des ausgewählten Datenwertes der dritten Größe eine Änderung des Clusterergebnisses des zweidimensionalen Verfahrens dargestellt wird.

14. Assistenzvorrichtung (80) zur Parametrisierung eines Anomalieerkennungsverfahrens, insbesondere ausgeführt in einer Anomalieerkennungsvorrichtung (90), basierend auf einer Vielzahl von Sensordatenpunkten mittels eines dichtebasierten Clusterverfahrens durchführt, **gekennzeichnet dadurch, dass** die Assistenzvorrichtung die folgenden Einheiten umfasst:
a) Abbildungseinheit (81), die derart ausgebildet ist, jeden Sensordatenpunkt (SP1, SP2, SP3) in einem Datenraum in einen Pixeldatenpunkt (PP1, PP2, PP3) in einem Pixelraum abzubilden,
b) Nachbildeeinheit (82), die derart ausgebildet ist, mindestens eine Operation des dichtebasierten Clusterverfahrens im Datenraum durch mindestens eine Pixeloperation im Pixelraum, der von einer Vielzahl von Pixeldatenpunkten aufgespannt wird, nachzubilden,
c) Eingabeeinheit (83), die derart ausgebildet ist, mindestens einen Parameterwert für jeden Parameter des dichtebasierten Clusterverfahrens zu empfangen,
d) Operationseinheit (84), die derart ausgebildet ist, mindestens eine Pixeloperation entsprechend den empfangenen Parameterwerten auf die Pixeldatenpunkte anzuwenden,
e) Ausgabeeinheit (85), die derart ausgebildet ist, Clusterergebnisse im Pixelraum in visueller Form auszugeben, und
f) Bereitstellungseinheit (86), die derart ausgebildet ist, die empfangenen Parameterwerte als Eingangsparameter für die Anomalieerkennungsverfahren bereitzustellen.

15. Assistenzvorrichtung nach Anspruch 14, wobei der Pixelraum durch eine Vielzahl von Pixel mindestens eines Teilbereichs der Ausgabeeinheit (85), insbesondere eines Bildschirms, ausgebildet ist.

16. Assistenzvorrichtung nach Anspruch 14 oder 15, wobei die Eingabeeinheit (83) und die Ausgabeeinheit (85) als eine graphische Nutzerschnittstelle ausgebildet sind, die derart ausgebildet ist, für mindestens einen Parameter ein graphisches Eingabeelement (72, 73) darzustellen und darüber die entsprechenden Parameterwerte auszuwählen und zu empfangen.

17. Computerprogrammprodukt umfassend ein nichtflüchtiges Computer-lesbares Medium, das direkt in einen Speicher eines digitalen Computers ladbar ist, umfassend Programmcodeteile, die dazu geeignet sind, die Schritte des Verfahrens nach einem der Ansprüche 1 bis 13 durchzuführen.

## Claims

1. Method for parameterizing an anomaly detection method which carries out a density-based cluster method on the basis of a multiplicity of sensor data points, **characterized by**
a) mapping (S10) each sensor data point (SP1, SP2, SP3) in a data space into a pixel data point (PP1, PP2, PP3) in a pixel space spanned by a multiplicity of pixel data points,
b) simulating (S11) at least one operation of the density-based cluster method in the data space by way of at least one pixel operation in the pixel space,
c) receiving (S12) at least one parameter value for each parameter of the density-based cluster method,
d) applying (S13) the at least one pixel operation to the pixel data points (PP1, PP2, PP3) according to the received parameter values,
e) outputting (S14) a cluster result in visual form in the pixel space, and
f) providing (S16) the received parameter values for the anomaly detection method.

2. Method according to Claim 1, wherein after outputting the cluster result, at least one of the parameter values is changed (S15) and method steps c), d) and e) are carried out again with the at least one changed parameter value.

3. Method according to either of the preceding claims, wherein the pixel space is spanned by a two-dimensional coordinate system, wherein a different variable (G1, G2) of the sensor data points (SP1, SP2, SP3) is assigned to each coordinate.

4. Method according to Claim 3, wherein the ratio of the extent of the two coordinates to one another corresponds in each case to the ratio of the value ranges of the assigned variable (G1, G2) of the sensor data points to one another, or at least one value range comprises normalized sensor data values or at least one value range comprises sensor data values according to a distribution function (30).

5. Method according to one of the preceding claims, wherein the cluster method is a density-based spatial cluster analysis method with noise (DBSCAN).

6. Method according to Claim 5, wherein a distance value (ε) is a first parameter of the cluster method and the minimum number (minPts) of sensor data points (SP1, SP2, SP3) for forming a cluster is a second parameter of the cluster method.

7. Method according to Claim 5 or 6, wherein determining core points (KP) from the multiplicity of sensor data points (SP1, SP2, SP3) is a first operation of the density-based cluster method in the data space and this first operation is mapped onto a first pixel operation in the pixel space, wherein the first pixel operation checks, for each sensor data point (SP1, SP2, SP3) to which a pixel data point (PP4) under consideration is assigned, whether the number of pixel data points which are arranged around the pixel data point (PP4) under consideration within a distance value according to the first received parameter value is equal to the second received parameter value or greater than the second received parameter value.

8. Method according to Claim 7, wherein the number of pixel data points around the pixel data point under consideration within a distance value according to the first received parameter is determined by determining all pixel data points which are arranged within a structure element (21), wherein the structure element (21) is arranged in a centred manner around the pixel data point (PP4) under consideration, and the spatial extent of the structure element is dependent on the first received parameter value (ε).

9. Method according to Claim 8, wherein a shape of the structure element (21) is dependent on a distance measure applied in the cluster method, in particular the structure element (21) is round for a Euclidean distance measure, the structure element (21) is rhomboidal for a Manhattan distance measure, and the structure element (21) is square for a Chebyshev distance measure.

10. Method according to one of Claims 6 to 9, wherein each pixel data point (PP1, PP2, PP3) in the pixel space is represented in a colour depending on a minimum distance between the pixel data point (PP1, PP2, PP3) and a nearest core point (KP).

11. Method according to one of Claims 6 to 10, wherein a contour (61, 62) of a cluster is displayed by representing in a coloured manner the pixel data points (PP1, PP2, PP3) which are at a distance of half the first parameter value (ε/2), preferably additionally the pixel data points which are at a distance of a whole first parameter value (ε), from a nearest core point (KP).

12. Method according to one of Claims 6 to 11, wherein the pixels are represented according to a shading depending on a spatial distribution of the core points in the pixel space.

13. Method according to one of Claims 1 to 3, wherein for more than two-dimensional sensor data points a two-dimensional method according to Claims 4 to 12 is carried out with two predefinable variables (dimensions) with respect to a selected data value of a third variable of the sensor data points and a change in the cluster result of the two-dimensional method is represented by way of a change in the selected data value of the third variable.

14. Assistance apparatus (80) for parameterizing an anomaly detection method, in particular implemented in an anomaly detection apparatus (90), carried out on the basis of a multiplicity of sensor data points by way of a density-based cluster method, **characterized in that** the assistance apparatus comprises the following units:
a) a mapping unit (81) configured in such a way as to map each sensor data point (SP1, SP2, SP3) in a data space into a pixel data point (PP1, PP2, PP3) in a pixel space,
b) a simulating unit (82) configured in such a way as to simulate at least one operation of the density-based cluster method in the data space by way of at least one pixel operation in the pixel space spanned by a multiplicity of pixel data points,
c) an input unit (83) configured in such a way as to receive at least one parameter value for each parameter of the density-based cluster method,
d) an operation unit (84) configured in such a way as to apply at least one pixel operation to the pixel data points according to the received parameter values,
e) an output unit (85) configured in such a way as to output cluster results in the pixel space in visual form, and
f) a providing unit (86) configured in such a way as to provide the received parameter values as input parameters for the anomaly detection method.

15. Assistance apparatus according to Claim 14, wherein the pixel space is configured by a multiplicity of pixels of at least one partial region of the output unit (85), in particular of a screen.

16. Assistance apparatus according to Claim 14 or 15, wherein the input unit (83) and the output unit (85) are configured as a graphical user interface configured in such a way as to represent a graphical input element (72, 73) for at least one parameter and by way of that to select and to receive the corresponding parameter values.

17. Computer program product comprising a non-volatile computer-readable medium which is loadable directly into a memory of a digital computer, comprising program code parts suitable for carrying out the steps of the method according to one of Claims 1 to 13.

## Revendications

1. Procédé pour paramétrer un procédé d'identification d'anomalie qui, en se basant sur une pluralité de points de données de capteur, exécute un procédé de cluster basé sur la densité, **caractérisé par**
a) la représentation (S10) d'un chaque point de données de capteur (SP1, SP2, SP3) dans un espace de données en un point de données de pixel (PP1, PP2, PP3) dans un espace de pixels qui est fixé par une pluralité de points de données de pixels,
b) reconstitution (S11) d'au moins une opération du procédé de cluster basé sur la densité dans l'espace de données par au moins une opération de pixel dans l'espace de pixels,
c) réception (S12) d'au moins une valeur de paramètre pour chaque paramètre du procédé de cluster basé sur la densité,
d) application (S13) sur les points de données de pixels (PP1, PP2, PP3) de l'au moins une opération de pixel conformément aux valeurs de paramètre reçues,
e) émission (S14) d'un résultat de cluster sous forme visuelle dans l'espace de pixels, et
f) fourniture (S16) des valeurs de paramètre reçues pour le procédé d'identification d'anomalie.

2. Procédé selon la revendication 1, dans lequel, après émission du résultat de cluster, au moins une des valeurs de paramètre est modifiée (S15) et les étapes de procédé c), d) et e) sont de nouveau exécutées avec l'au moins une valeur de paramètre modifiée.

3. Procédé selon l'une des revendications précédentes, dans lequel l'espace de pixels est fixé par un système de coordonnées bidimensionnel, dans lequel une grandeur différente (G1, G2) des points de données de capteur (SP1, SP2, SP3) est attribuée à chaque coordonnée.

4. Procédé selon la revendication 3, dans lequel le rapport de l'extension des deux coordonnées entre elles correspond respectivement au rapport des plages de valeur de la grandeur (G1, G2) attribuée des points de données de capteur entre elles, ou au moins une plage de valeurs comprend des valeurs de données de capteur normalisées ou au moins une plage de valeurs comprend des valeurs de données de capteur correspondant à une fonction de répartition (30).

5. Procédé selon l'une des revendications précédentes, dans lequel le procédé de cluster est un procédé d'analyse de cluster avec bruit (DBSCAN) spatial basé sur la densité.

6. Procédé selon la revendication 5, dans lequel
une valeur de distance (ε) est un premier paramètre du procédé de cluster et le nombre minimal (minPts) de points de données de capteur (SP1, SP2, SP3) pour former un cluster est un deuxième paramètre du procédé de cluster.

7. Procédé selon la revendication 5 ou 6, dans lequel une détermination de points essentiels (KP) de la pluralité de points de données de capteur (SP1, SP2, SP3) est une première opération du procédé de cluster basé sur la densité dans l'espace de données, et cette première opération est reproduite sur une première opération de pixel dans l'espace de pixels, dans lequel la première opération de pixel vérifie pour chaque point de données de capteur (SP1, SP2, SP3) auquel un point de données de pixels (PP4) considéré est attribué, si le nombre de points de données de pixels qui sont disposés à l'intérieur d'une valeur de distance correspondant à la première valeur de paramètre reçue autour du point de données de pixels (PP4) considéré, est égal à la deuxième valeur de paramètre reçue ou supérieur à la deuxième valeur de paramètre reçue.

8. Procédé selon la revendication 7, dans lequel le nombre de points de données de pixels à l'intérieur d'une valeur de distance correspondant au premier paramètre reçu autour du point de données de pixels considéré est déterminé par la détermination de tous les points de données de pixels qui sont disposés à l'intérieur d'un élément structurel (21), dans lequel l'élément structurel (21) est disposé centré autour du point de données de pixels (PP4) considéré, et l'extension spatiale de l'élément structurel dépend de la première valeur de paramètre (ε) reçue.

9. Procédé selon la revendication 8, dans lequel une forme de l'élément structurel (21) dépend d'une mesure de distance appliquée dans le procédé de cluster, en particulier, l'élément structurel (21) est rond pour une mesure de distance euclidienne, l'élément structurel (21) est en forme de losange pour une mesure de distance de Manhattan, l'élément structurel (21) est carré pour une mesure de distance de Chebyshev.

10. Procédé selon l'une des revendications 6 à 9, dans lequel chaque point de données de pixel (PP1, PP2, PP3) dans l'espace de pixels est représenté dans une couleur en fonction d'une distance minimale du point de données de pixel (PP1, PP2, PP3) à un point essentiel (KP) suivant.

11. Procédé selon l'une des revendications 6 à 10, dans lequel un contour (61, 62) d'un cluster est affiché par une représentation en couleur des points de données de pixel (PP1, PP2, PP3) qui présentent un espacement de la moitié de la première valeur de paramètre (ε/2), de préférence des points de données de pixels en plus qui présentent un espacement d'une première valeur de paramètre (ε) entière d'un point essentiel (KP) qui suit.

12. Procédé selon l'une des revendications 6 à 11, dans lequel les pixels sont représentés dans l'espace de pixels conformément à un estompage en fonction d'une distribution spatiale des points essentiels.

13. Procédé selon l'une des revendications 1 à 3, dans lequel pour des points de données de capteur plus que bidimensionnels, un procédé bidimensionnel selon les revendications 4 à 12 est exécuté avec deux grandeurs (dimensions) pour une valeur de donnée sélectionnée d'une troisième grandeur des points de données de capteur, et une modification du résultat de cluster du procédé bidimensionnel est représentée par une modification de la valeur de donnée sélectionnée de la troisième grandeur.

14. Dispositif d'assistance (80) pour paramétrer un procédé d'identification d'anomalie, exécuté en particulier dans un dispositif d'identification d'anomalie (90), exécuté en étant basé sur une pluralité de points de données de capteur au moyen d'un procédé de cluster basé sur la densité, **caractérisé en ce que** le dispositif d'assistance comprend les unités suivantes :
a) une unité de représentation (81) qui est conçue pour représenter chaque point de données de capteur (SP1, SP2, SP3) dans un espace de données en un point de données de pixel (PP1, PP2, PP3) dans un espace de pixels,
b) une unité de reconstitution (82) qui est conçue pour reconstituer au moins une opération du procédé de cluster basé sur la densité dans l'espace de données par au moins une opération de pixel dans l'espace de pixels, qui est fixé par une pluralité de points de données de pixels,
c) une unité de saisie (83) qui est conçue pour recevoir au moins une valeur de paramètre pour chaque paramètre du procédé de cluster basé sur la densité,
d) une unité d'opération (84) qui est conçue pour appliquer sur les points de données de pixel au moins une opération de pixel conformément aux valeurs de paramètre reçues,
e) une unité d'émission (85) qui est conçue pour émettre des résultats de cluster sous forme visuelle dans l'espace de pixels, et
f) une unité de fourniture (86) qui est conçue pour fournir les valeurs de paramètre reçues en tant que paramètres d'entrée pour le procédé d'identification d'anomalie.

15. Dispositif d'assistance selon la revendication 14, dans lequel l'espace de pixels est formé par une pluralité de pixels d'au moins une partie de l'unité d'émission (85), en particulier d'un écran.

16. Dispositif d'assistance selon la revendication 14 ou 15, dans lequel l'unité de saisie (83) et l'unité d'émission (85) sont conçues en tant qu'une interface utilisateur graphique qui est conçue pour représenter un élément de saisie (72, 73) graphique pour au moins un paramètre et sélectionner et recevoir là-dessus les valeurs de paramètre correspondantes.

17. Produit de programme informatique comprenant un support non volatile lisible sur ordinateur qui peut être chargé directement dans une mémoire d'un ordinateur numérique, comprenant des parties de code de programme qui sont appropriées pour exécuter les étapes du procédé selon l'une des revendications 1 à 13.
